# EUROPÄISCHE PATENTANMELDUNG

(11) **EP 1 458 227 A2**
(43) Veröffentlichungstag der Anmeldung: **15.09.2004**
(21) Anmeldenummer: 03104507.3
(22) Anmeldetag: 03.12.2003
(51) Int. Cl.: H05K 13/04

(54) **Vorrichtung zum Bestücken von Substraten mit elektrischen Bauelementen**

(30) Priorität: 12.03.2003 DE 10310799
(71) Anmelder: SIEMENS AKTIENGESELLSCHAFT, 80333 München (DE)
(72) Erfinder: Berndl, Erhard, 82008, Unterhaching (DE)

(57) **Zusammenfassung**

Zuführeinrichtungen (5) können mittels verstellbarer Zwischenträger (15) in unterschiedlichen Positionen an einem Chassis der Vorrichtung fixiert werden. Dadurch ist es möglich die Verfahrwege von Bestückköpfen (13) für elektrische Bauelemente (10) zu minimieren.

## Beschreibung

Die Erfindung bezieht sich auf eine Vorrichtung zum Bestücken von Substraten mit elektrischen Bauelementen, die in zumindest einer Zuführeinrichtung bereitgestellt werden, die in einem Zuführbereich der Vorrichtung angebracht werden kann, wobei die Zuführeinrichtung in definierter Lage an einem Chassis der Vorrichtung fixierbar ist.

Eine derartige Vorrichtung ist zum Beispiel durch die EP 0951810 B bekannt geworden. Danach weist eine Zuführeinrichtung einen tischartigen Träger für eine Vielzahl von Zuführmodulen auf, mit denen die in Gurten bereitgestellten Bauelemente an definierten Abholstellen transportiert werden können. Der tischartige Träger wird mittels Zentrierstiften an einem Chassis der Bestückvorrichtung wechselbar fixiert. Dabei ist es üblich, die Zuführeinrichtung in einem Abstand zu einem Bestückplatz anzuordnen, der die Bestückung von sehr breiten Leiterplatten ermöglicht. Ferner sind üblicherweise zwischen den Zuführmodulen und der zu bestückenden Leiterplatte Zubehöreinrichtungen vorgesehen, z. B. in Form von Wechselmagazinen für unterschiedliche Saugpipetten eines Bestückkopfes. Andere Zubehöreinrichtungen sind z. B. ein Abwurfschacht für fehlerhafte Bauelemente oder eine stationäre Kamera zum optischen Vermessen der abgeholten Bauelemente.

Der Erfindung liegt die Aufgabe zugrunde, die Abstände zwischen der Leiterplatte und den Zuführmodulen zu verringern.

Diese Aufgabe wird durch die Erfindung gemäß Anspruch 1 gelöst. Durch den verstellbaren Zwischenträger ist es möglich, die Zuführeinrichtungen je nach Breite der Leiterplatte bzw. je nach Breite der Zubehörteile in unterschiedlichen Positionen fest am Chassis zu verankern. Beispielsweise benötigt ein Vielfachkopf mit einer großen Anzahl von Saugpipetten entsprechend große Wechselmagazine mit vielen unterschiedlichen Pipetten. Durch die Verwendung des verstellbaren Zwischenträgers ist es möglich, den Abstand zwischen der Zuführeinrichtung und der Leiterplatte auf ein Minimum zu verringern. Beispielsweise können sämtliche Zubehörteile auf einer Seite des Bestückfeldes angeordnet werden, so dass die Zuführeinrichtung auf der gegenüberliegenden Seite unmittelbar an das Bestückfeld herangerückt werden kann. Es ist aber auch möglich, den Zwischenträger völlig zu entfernen, und den für diesen benötigten Raum für spezielle Zuführeinrichtungen, z. B. für Flächenmagazinwechsler vollständig zu nutzen.

Nach einer vorteilhaften Weiterbildung der Erfindung ist der Zwischenträger als U-förmig verlaufendes Rahmenteil ausgebildet, das mit seinen Seitenschenkeln am Chassis in verschiedenen Stellungen befestigt werden kann. Die offene Seite des Rahmenteils ermöglicht es, die Zuführeinrichtungen durch einen waagerechten Einschiebevorgang zu wechseln.

Nach einer anderen Weiterbildung der Erfindung ist der Zwischenträger mit einem wechselbaren Träger für Zubehörteile versehen. Damit sind diese dem Rahmenteil zugeordnet und mit diesem verstellbar. Die Zubehörteile können zum Beispiel als Pipettenmagazin, als Kamera zum Vermessen der Bauelemente oder als Abwurfschacht für fehlerhafte Bauelemente ausgebildet sein. Bei der Verwendung eines Bestückkopfes mit einer eigenen Kamera kann die am Zwischenträger fixierte Kamera entfernt werden.

Im Folgenden wird die Erfindung anhand eines in der Zeichnung dargestellten Ausführungsbeispieles näher erläutert.
- Figur 1: zeigt in einer schematisierten perspektivischen Ansicht eine Vorrichtung zum Bestücken von Leiterplatten mit elektrischen Bauelementen,
- Figur 2: eine Draufsicht auf die Vorrichtung nach Figur 1,
- Figur 3: einen vergrößerten Schnitt durch die Vorrichtung entlang der Linie III-III in Figur 1.

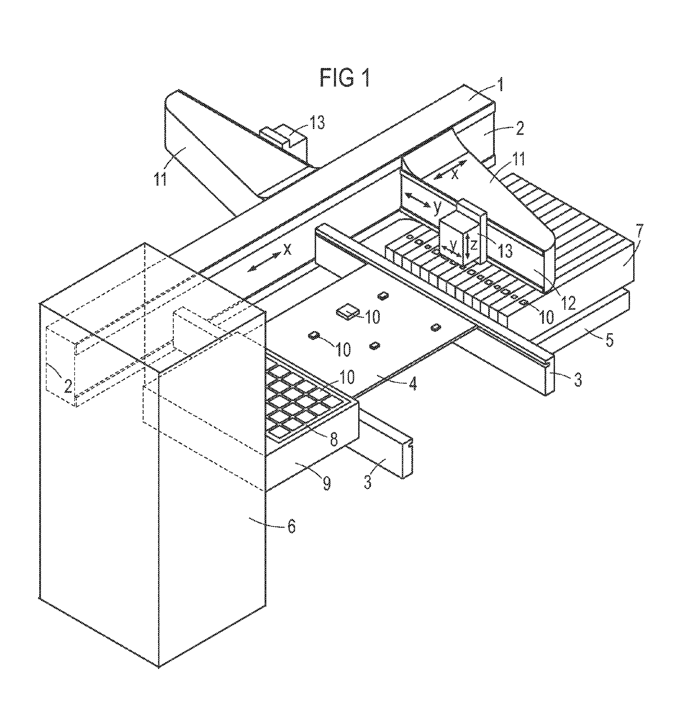

Nach Figur 1 weist ein trägerartiges Chassisteil 1 zwei waagerecht verlaufende lineare Längsführungen 2 auf, die sich in einer Koordinatenrichtung X erstrecken. An das Chassisteil 1 grenzt ein Tisch 3 an, auf dem ein als Leiterplatte ausgebildetes Substrat 4 fixiert ist. Zu beiden Seiten des Tisches 3 sind Zuführeinrichtungen 5, 6 für elektrische Bauelemente 10 angeordnet, wobei eine erste Zuführeinrichtung als Bauelementetisch 5 mit aneinandergereihten Zuführmodulen 7 und eine zweite Zuführeinrichtung als Flächenmagazin 6 ausgebildet ist, das übereinandergestapelte Flächenmagazine 8 aufweist, die wahlweise auf einer Ablage 9 neben dem Tisch 3 bereitgestellt werden können. Ähnliche Einrichtungen sind auf der dem Tisch 3 gegenüberliegenden Seite des Chassisteils 1 angeordnet, aber nicht dargestellt.

An den beiden Längsführungen 2 sind in der Längsrichtung Positionierarme 11 verschiebbar, die freiragend senkrecht zur Längsführung 2 abstehen. Die Positionierarme 11 sind ihrerseits mit einer waagerechten Querführung 12 versehen, in der ein Bestückkopf 13 in einer Y-Richtung verfahrbar ist. Die an den Zuführmodulen 7 bzw. im Flächenmagazin 8 bereitgestellten Bauelemente 10 sowie das Substrat 4 befinden sich annähernd in einer Ebene, zu der ein nicht näher dargestellter Greifer des Bestückkopfes 13 in einer senkrechten Z-Richtung auf und ab bewegt werden kann. Der Bestückkopf 13 ist innerhalb der durch die X- und Y-Achse gebildeten Arbeitsebene zwischen den Abholstellen und den Aufsetzstellen der Bauelemente 10 verfahrbar, wobei die exakten Arbeitspositionen durch die entsprechende Positionierung des Positionierarmes 11 in der Längsführung 2 sowie des Bestückkopfes 13 in der Querführung 12 eingestellt werden.

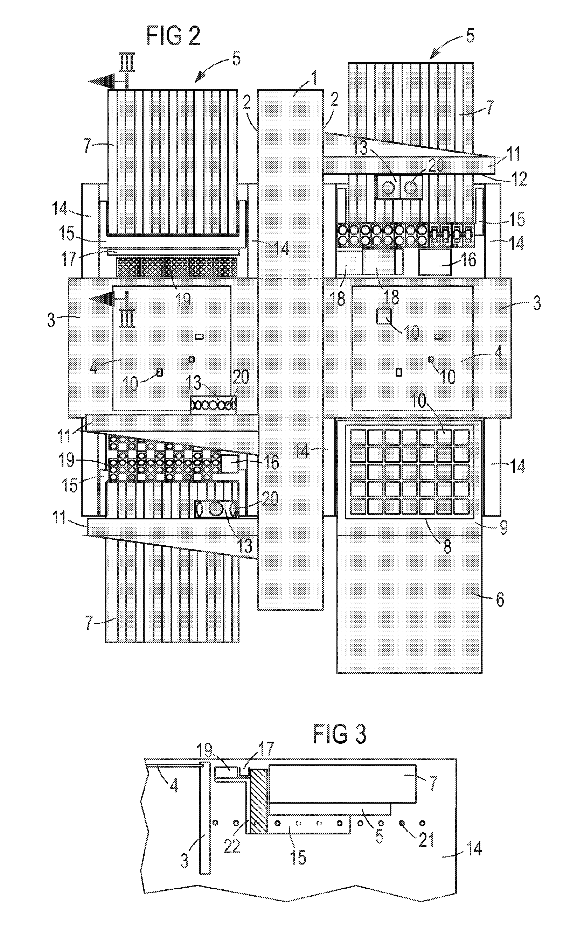

In Figur 2 sind die Teile nach Figur 1 in einer leicht vereinfachten Form dargestellt und um zusätzliche Teile ergänzt. Die Vorrichtung ist zu beiden Seiten des trägerartigen Chassisteils 1 annähernd symmetrisch ausgebildet und mit je einem der Tische 3 versehen, zu deren beiden Seiten die Zuführeinrichtungen 5, 6 angeordnet sind. Sich in der Richtung des Chassisteils 1 erstreckende Wandteile 14 des Chassis bilden Trägerelemente für U-förmig verlaufende Zwischenträger 15, an denen die Zuführeinrichtungen 5 befestigt werden können. Der breitere Flächenmagazinwechsler 6 ist unter Weglassung des Zwischenträgers 15 unmittelbar an den Wandteilen 14 in unmittelbarer Nachbarschaft des Tisches 3 befestigt. Die Bauelementetische 5 mit den Zuführmodulen 7 sind über die Zwischenträger 15 mit den Wandteilen 14 verbunden, die in unterschiedlichem Abstand zum Tisch 13 positionierbar sind. Zwischen den Bauelementetischen 5 und den Tischen 3 sind Zubehörteile angeordnet, die z. B. als Abwurfbehälter 16, Abwurfrinne 17, Kameras 18 und verschiedenartige Pipettenmagazine 19 ausgebildet sind.

Auf der dem Flächenmagazinwechsler 6 gegenüberliegenden Seite des Chassisteils 1 sind zwei der Positionierarme 11 mit unterschiedlichen revolverartigen Bestückköpfen 13 mit einer Vielzahl von Greifern 20 für die Bauelemente 10 angeordnet. Diese Bestückköpfe können abwechselnd die Bauelemente 10 von den Zuführmodulen 5 abholen und auf das Substrat 4 aufsetzen. Auf der gegenüberliegenden Seite des Chassisteils 1 ist nur einer der Positionierarme 11 vorgesehen, dessen Bestückkopf 13 mit zwei Greifern 20 für die Bauelemente 10 versehen ist.

Nach Figur 3 weisen die Wandteile 14 je eine Reihe von Befestigungslöchern 21 für die Zwischenträger 15 auf. Je nach dem für die Zubehörteile benötigten Raum können die Zwischenträger 15 in unterschiedlichen Befestigungslöchern 21 fixiert werden. Die Zwischenträger 15 sind außerdem mit nicht näher dargestellten Fixiermitteln für die Bauelementetische 5 mit den Zuführmodulen 7 versehen. Sie weisen auf ihrer dem Tisch 3 zugewandten Seite wechselbare Träger 22 für die unterschiedlichen Zubehörteile 16 bis 19 auf.

### Bezugszeichen

- 1: Chassisteil
- 2: Längsführung
- 3: Tisch
- 4: Substrat
- 5: Bauelementetisch
- 6: Flächenmagazinwechsler
- 7: Zuführmodul
- 8: Flächenmagazin
- 9: Ablage
- 10: Bauelement
- 11: Positionierarm
- 12: Querführung
- 13: Bestückkopf
- 14: Wandteil
- 15: Zwischenträger
- 16: Abwurfbehälter
- 17: Abwurfrinne
- 18: Kamera
- 19: Pipettenmagazin
- 20: Greifer
- 21: Befestigungsloch
- 22: Träger

## Patentansprüche

1. Vorrichtung zum Bestücken von Substraten (4) mit elektrischen Bauelementen (10), die in zumindest einer Zuführeinrichtung (5, 6) bereitgestellt werden, die in einem Zuführbereich der Vorrichtung angebracht werden kann, wobei die Zuführeinrichtung (5, 6) in definierter Lage an einem Chassis der Vorrichtung fixierbar ist,
**dadurch gekennzeichnet, dass** in den Zuführbereichen je ein Zwischenträger (15) vorgesehen ist, an dem die Zuführeinrichtungen (5) fixierbar sind und
dass der lösbare Zwischenträger (15) am Chassis verstellbar verankerbar ist.

2. Vorrichtung nach Anspruch 1,
**dadurch gekennzeichnet, dass** der Zwischenträger (15) als U-förmig verlaufendes Rahmenteil ausgebildet ist.

3. Vorrichtung nach Anspruch 1 oder 2,
**dadurch gekennzeichnet, dass** der Zwischenträger (15) mit wechselbaren Trägern (22) für Zubehörteile (16 bis 19) versehen ist.
